# EUROPEAN PATENT SPECIFICATION

(11) **EP 3 225 080 B1**
(45) Date of publication and mention of the grant of the patent: **02.01.2019**
(21) Application number: 15823008.6
(22) Date of filing: 26.11.2015
(51) Int. Cl.: H05B 7/06

(54) **DIRECT CURRENT ELECTRIC ARC FURNACE FOR METALLURGICAL PLANT**
GLEICHSTROMELEKTROLICHTBOGENOFEN FÜR EIN METALLERZEUGENDES WERK
FOUR À ARC ÉLECTRIQUE À COURANT CONTINU POUR USINE MÉTALLURGIQUE

(30) Priority: 27.11.2014 IT MI20142045
(43) Date of publication of application: 04.10.2017
(73) Proprietor: Danieli & C. Officine Meccaniche S.p.A., 33042 Buttrio (IT)
(72) Inventor: MORSUT, Stefano, 33100 Udine (IT); FORNO, Ferdinando, 33030 Moruzzo (IT); CODUTTI, Andrea, 33030 Moruzzo (IT); PICCIOTTO, Maurizio, 33100 Udine (IT)
(74) Representative: Celona, Antonio
(86) International application number: PCT/IB2015/059144
(87) International publication number: WO 2016/084028

(56) References cited:
- EP-A1- 0 203 301
- EP-A1- 0 219 649
- EP-A1- 0 428 150
- JP-A- H0 350 489
- US-A- 5 268 924

## Description

### FIELD OF THE INVENTION

The present invention relates to a direct current electric arc furnace usable in a metallurgical plant.

### BACKGROUND ART

Direct current electric furnaces (also known with the acronym DC EAFs, Direct Current Electric Arc Furnaces) are used mainly in the steel industry for melting and refining iron-based metal alloys.

In these furnaces, the electric arc is discharged between at least one graphite electrode arranged above (cathode) and at least one bottom electrode (anode) arranged below in the base sole of the furnace. The passing of the current allows the formation of the electric arc whose effects of radiation and convection allow the melting of the metal material previously introduced into the furnace.

With respect to alternate current arc furnaces (also known with the acronym AC EAFs, Alternate Current Electric Arc Furnaces), direct current furnaces advantageously allow:
- less consumption of electric energy,
- less consumption of the graphite electrodes,
- less wear of the refractory materials in the structure of the furnace,
- a greater length of arc with subsequent, more uniform and faster melting of the metal material inside the furnace,
- a decrease in the noise and the mechanical stresses,
- a greater remixing of the melted liquid metal bath inside the furnace,
- less variation of reactive power,
- a reduced flicker effect.

Typically, direct current electric furnaces have an upper electrode or cathode, restrained to a movement system which extends through the roof inside the furnace itself, and a plurality of lower electrodes or bottom electrodes or anodes, restrained to the furnace bottom and incorporated in the base sole of the furnace, made of refractory material, so as to make a hearth which receives the melted metal bath. An example of direct current electric arc furnace is disclosed in EP0428150A1.

The anodes in these furnaces are one of the most delicate components as they are crossed by currents having very high intensity and are subject to significant thermal stresses and electromagnetic forces.

The hearth of the furnace is formed by a lower steel framework and by a covering made of refractory ceramic material, which protects the load-bearing steel structures thereof from the thermal stresses due to the bath of liquid steel, or other metal contained therein. A further problem to be considered in an electric furnace, and in particular in a DC direct current furnace, concerns the cooling of the furnace bottom. If the furnace bottom constantly maintains very high temperatures, this negatively affects the duration of the base and of the insulating materials which prevent part of the electric current circulating in the anodes from reaching the framework of the furnace and damaging it. The wear of the covering decreases the safety of the work environment and there is a need to frequently change the hearth, an operation which stops the plant. Therefore, many known solutions provide cooling the framework forming the furnace bottom, and in particular the body of the anodes. Among other things, such a precaution is also required to prevent the formation of possible escape routes for the melted metal. Consider that the conductors arranged below the shell are cooled with water in order to supply the high intensity currents of the anodes. In such a situation, if the fusion front inside the anode should continue up to completely perforating the anode base, contact would occur of the liquid metal with the water or other cooling liquid used to cool down the anode base, thus causing a highly dangerous explosive reaction.

Thus, there is a need for making a bottom electrode which is capable of overcoming the aforesaid drawbacks.

### SUMMARY OF THE INVENTION

It is the main object of the present invention to make a type of bottom electrode which is capable of ensuring an average temperature of the electrodes which is significantly lower than that of the state of the art and, subsequently, greater safety.

It is a further object of the present invention to make a type of bottom electrode which is capable of ensuring a temperature of the furnace bottom which is significantly lower than that of the state of the art and, subsequently, a lower thermo-mechanical and chemical stress thereof.

It is a further object of the present invention to make a type of bottom electrode whose capacity for electric current passage tends to be uniform between the bottom electrodes and in which the intensity of electric current is lower with respect to the state of the art, thus ensuring a decreased wear of the electrodes.

It is another object of the present invention to make a type of bottom electrode which is capable of ensuring greater duration of the electric insulators separating the elements involved by the electrical conduction with respect to the framework forming the furnace bottom, since a lower temperature preserves the refractory covering and therefore causes less wear thereof.

Such objects are achieved by means of a direct current electric arc furnace for metallurgical plant which, according to claim 1, comprises at least one bottom electrode having a plurality of metal bars, parallel to one another and defining respective longitudinal axes, and a support flange adapted to support and electrically supply said metal bars, characterized in that each metal bar comprises at least a first portion which includes a first end of the bar, and at least a second portion which is axially adjacent to said first portion and which includes a second end of the bar, said first portion being restrained to said support flange at the first end, and having greater thermal conductivity with respect to said second portion.

Due to the metal bars formed by at least two portions made of different materials, preferably copper or alloys thereof for the first portion and steel for the second portion, it is possible to obtain significantly improved cooling of the furnace bottom, and in particular of the layer of refractory material, with respect to the known art. The greater thermal conductivity of the first portion of the bars of the electrode, which is closer to the bottom and therefore to the cooling system which may be provided in such a zone, allows a greater cooling efficiency to be obtained of the entire furnace bottom.

Advantageously, the support flange comprises at least a first plate or upper plate, distal from the first ends of the bars, and at least a second plate or lower plate, proximal to the first ends of the bars, the first plate and the second plate being substantially flat and parallel and arranged so as to form a gap between one another, and in which each first end of the bars is fixed to the lower plate. Due to such a gap, a cooling fluid can lap the surface of part of the first portions to obtain the cooling of the metal bars. The plates can be substantially circular or can have another shape, for example square.

The lower plate of the support flange allows the distribution of the electric current to the metal bars. Such supply can occur by means of a single central electrical contact, supplied for example by a tubular casing arranged in the middle part of the flange, or by means of a plurality of electrical contacts arranged at the periphery of the flange, which make the supply peripheral-radial. Advantageously, such a peripheral-radial supply allows a more uniform passage of current and an improved thermal behavior with respect to a single central supply, which involves increased wear of the metal bars close to such a supply due to the greater concentration of current with respect to the perimeter bars.

Preferably, the lower plate of the flange is divided into a plurality of sectors which can have the same shape and the same size. For example, two, three, four or more sectors can be provided having the same shape and the same size. The division can be achieved, for example, by means of milling. Each sector can be supplied by the single central electrical contact, or each sector can be supplied by a respective peripheral electrical contact. The current is distributed to smaller areas by means of the division into sectors, thus ensuring an improved distribution uniformity of the current, which involves less wear of the bars.

Preferably, the lower plate of the support flange is formed by a bimetallic sheet, that is formed by two overlapping layers fixed to one another, for example by means of welding or brazing, of which the first layer is proximal to the upper plate of the support flange and is preferably made of steel, and the second layer is distal from the upper plate of the support flange and is made of a material, which is preferably copper or alloys thereof, with greater electrical conductivity with respect to the material of the first layer. Even more preferably, the second layer is divided into a plurality of sectors, for example by machining the surface, which can have the same shape and the same size. In a particularly preferred manner, two, three, four or more sectors are provided having the same shape and the same size. Each sector can be supplied by the single central electrical contact, or each sector can be supplied by a respective peripheral electrical contact.

Preferably, the first and the second portion are fixed to one another by means of welding, or by means of brazing, or by means of threaded coupling.

Preferably, the diameter of each bar ranges between 20 and 100 mm, even more preferably it ranges between 20 and 60 mm.

Furthermore, the diameter of the bars can be constant or can vary along the length thereof. In particular, the diameter of the first portion is preferably greater than the diameter of the second portion of each bar. In this case, a variable diameter transition zone can be provided between the first and the second portion.

Preferably, a series of annular grooves can be obtained on the first portion of the bars, therefore defining a series of corresponding annular tabs for improving the heat exchange with the cooling fluid which flows through the gap.

Preferably, the number of the bars ranges between 100 and 600, even more preferably between 200 and 400.

The first and the second portion of the bars can be equal or different in length. Preferably, the length of the first portion is greater than the length of the second portion.

Each bar is typically incorporated in a matrix of refractory material or base sole starting from the second end up to the joining point with the first portion above the upper plate. Alternatively, the second end of each bar can protrude slightly past the upper surface of such a base sole.

### BRIEF DESCRIPTION OF THE DRAWINGS

Further features and advantages of the invention will be more apparent in the light of the detailed description of preferred, but not exclusive, embodiments of a direct current electric arc furnace according to the present invention, disclosed by way of a non-limiting example, with the aid of the accompanying drawings in which:
Figure 1 shows an axonometric section plane view of a part of an electric arc furnace according to the present invention;
Figure 2 shows a bottom plan view of a part of a first embodiment of a bottom electrode according to the invention;
Figure 3 shows a sectional side view of said first embodiment of bottom electrode;
Figure 4a shows a sectional view of a first variant of a component of the bottom electrode according to the invention;
Figure 4b shows a sectional view of a second variant of the component in Fig. 4a;
Figure 4c shows an enlarged detail of Figure 4b;
Figure 5 shows an axonometric view of a second embodiment of a bottom electrode according to the invention;
Figure 6 shows a bottom plan view of the part of bottom electrode shown in Fig. 5;
Figures 7a and 7b show the distribution of heat along a bar made of a single material and along a bar made of two materials, respectively.

### DETAILED DESCRIPTION OF THE INVENTION

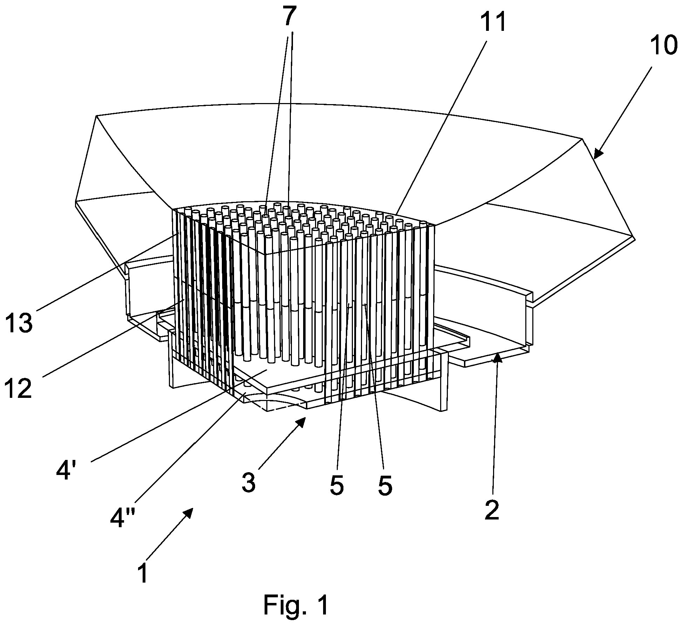

With reference to Figure 1, a direct current electric arc furnace, only partly depicted, is indicated as a whole with numeral 1. Furnace 1 is described only partly with particular reference to the elements that distinguish it from known furnaces. The parts of the furnace not described in detail are intended in themselves known and conventional. Furnace 1 comprises a bottom 2, which includes one or more bottom electrodes 3, or lower electrodes, typically supplied electrically by the positive polarity, incorporated in a base sole 10, which acts as a matrix, made of refractory material, preferably high melting point ceramic. Figure 1 shows a single bottom electrode 3. Bottom 2 is part of the base sole 10 of furnace 1. The base sole 10 further comprises an upper surface 11 susceptible to being in contact with the metal mass or metal bath contained in furnace 1.

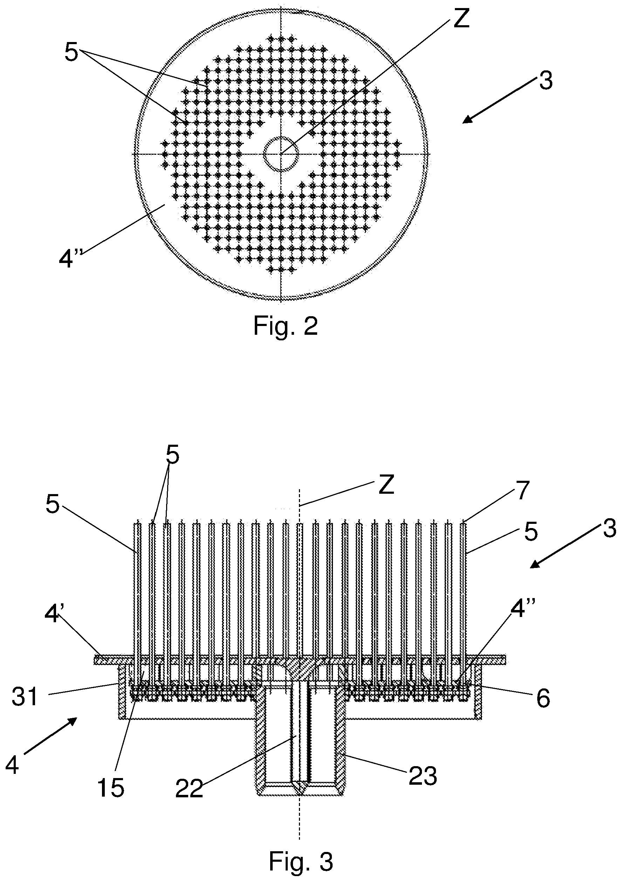

With reference to Figures 1 to 3, the bottom electrode 3 comprises a base or support flange 4. Flange 4 is provided with an upper plate 4' and a lower plate 4", which are made of metal material, are substantially flat and circular, are arranged parallel to one another, and have the respective center arranged on a same axis. In particular, axis Z is defined to be passing through such centers and is orthogonal to the flat surfaces of the two plates. A gap 15 is defined between the two plates 4', 4", in which a cooling fluid is passed. The bottom electrode 3 further comprises a plurality of straight metal bars 5, which are orthogonal to the plates 4', 4" and are fixed to the lower plate 4" at respective first axial ends 6 of the bars themselves. Second axial ends 7, opposite to the first ends 6, are arranged close to the upper surface 11 of the base sole 10. Each of the metal bars 5 is extended along the longitudinal axis thereof, parallel to axis Z, and crosses the lower plate 4", the upper plate 4' and the base sole 10. The second axial end 7 of the bars 5 protrudes slightly past the upper surface 11, crossing it, so as to be in contact with the metal mass or bath contained in the furnace. However, there is no need for the second ends 7 to be protruding with respect to the upper surface 11. Furthermore, in this embodiment, the section of each metal bar 5 is circular along a plane orthogonal to the longitudinal axis thereof, but other shapes can also be provided for such a section, for example square. A rod 22, surrounded by a casing or tubular conduit 23, extends from the center of the upper plate 4'. Rod 22 has the longitudinal axis thereof coincident with axis Z and extends axially in opposite direction with respect to the extension of the metal bars 5. Rod 22 is adapted to ensure the equipotentiality of the system. The lower plate 4" is in contact with casing 23 and allows the distribution of the electric current to the metal bars 5. Indeed, casing 23, which extends in the same direction as rod 22, provides an electrical contact for the power supply. Preferably, casing 23 is tubular in shape and is fixed in a middle opening of plate 4", so as to provide a conduit for conveying the cooling fluid into gap 15. Flange 4 is also provided with a skirt 31, which extends in the same direction as rod 22. The upper portion of skirt 31 is fixed, for example by means of welding or brazing, to the lower surface of the upper plate 4'.

Furnace 1 further comprises at least one upper electrode, not shown in the accompanying drawings, opposite with respect to the at least one lower electrode, and typically supplied by the negative polarity. The second portion of the bottom electrodes is always in contact with the liquid metal bath, for example steel, or in any case with the metal mass still in the solid state. There is current passage between the metal bath or mass and the at least one upper electrode, through the formation of an electric arc which constitutes the heat energy source of the furnace.

The metal bars 5 have a small diameter, for example ranging between 20 and 100 mm, preferably ranging between 40 and 60 mm, to limit the adduction effect of heat energy by the high temperature metal bath, which is typically proportional to the square of such a diameter. Only by way of example, in the embodiment shown, there are about 350 metal bars. The number of such bars can be different for each bottom electrode, for example ranging between 100 and 600, preferably between 200 and 400.

The metal bars 5 are conveniently distributed according to a matrix, being uniformly distributed between each other, within a substantially circular area on a plane defined by the support flange 4, they are substantially parallel to each other, and they are axially orthogonal to the support flange 4. However, many other distributions are possible, for example a triangular mesh, spiral, or distributed along a plurality of radial directions starting from the middle of one of the plates. The pitch of the arrangement of the bars is conveniently selected so as to balance the distribution of the current and the heat contribution of the bath compatibly with the dimensions of the elements for fixing the bars 5 to the lower plate 4".

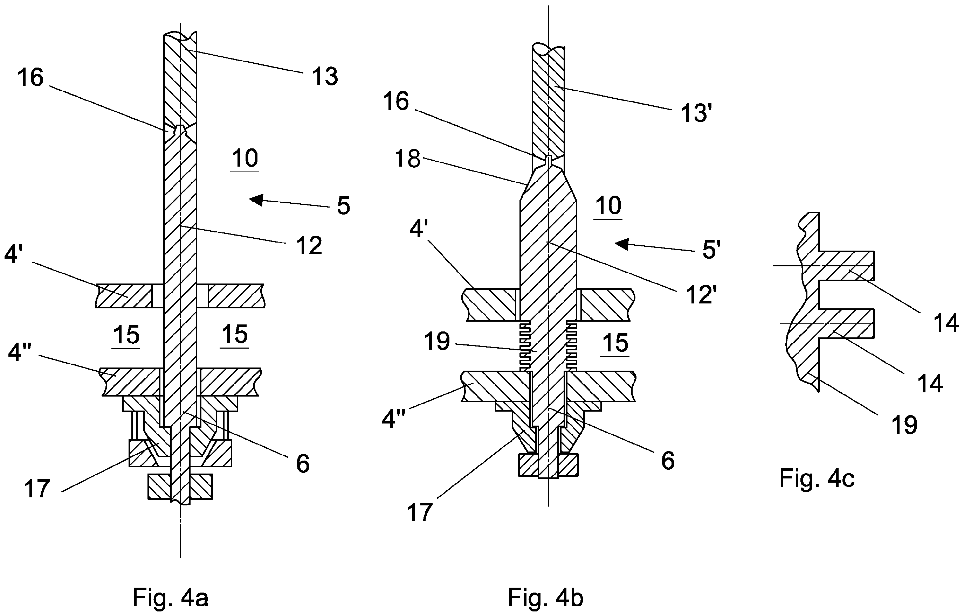

Figure 4a shows a detail of the bottom electrode 3. As described above, flange 4 comprises the upper plate 4' and the lower plate 4", made of metal material. Said plates 4' and 4" are arranged so as to be spaced from and parallel to one another, thus forming gap 15, and they are oriented orthogonally with respect to the metal bars 5. The upper plate 4' is in contact with the base sole 10. The upper 4' and lower 4" plates are provided with a plurality of holes, through which the metal bars 5 are inserted. In particular, the first axial end 6 of each metal bar 5 is fixed to the lower plate 4" by means of a threaded coupling 17 of the screw and nut type. A different type of coupling can also be provided, for example a snap coupling between the first ends 6 and the lower plate 4".

Air is circulated through gap 15 between the lower and upper plates 4', 4", possibly air containing nebulized water, which laps the metal bars 5 to promote the cooling thereof. Such a cooling fluid is preferably, but not necessarily, introduced by means of the lower opening of casing 23.

Each metal bar 5 is made in two separate, axially adjacent portions 12, 13. The first portion 12 comprises the first axial end 6 and is made of a metal with high thermal conductivity so as to effectively transmit the cooling action of the air circulating in gap 15. The first portion 12 is preferably made of high thermal and electric conductivity metal, for example copper or other material having a minimum thermal conductivity value equal to 386 W/m°C. The second portion 13 of each metal bar 5 comprises the second axial end 7 and is made of a high melting point metal, preferably steel or other material with a minimum melting point value equal to 1500 °C. Advantageously, the second portions 13 are made with the same material as the metal to be melted, so as to melt during the operation of the furnace and to take on electrical continuity with the metal bath. During the steps of low thermal operation or of the plant being switched off, the liquid metal solidifies thus regenerating the bars inside the base sole 10.

Only by way of example, in the embodiment shown, the first portion 12 has a length or longitudinal extension equal to approximately 600-650 mm and the second portion 13 has a length or longitudinal extension equal to approximately 470-520 mm. However, different lengths are possible for each portion 12, 13. For example, the length of the first portion 12 can be equal to the length of the second portion 13, up to being equal to approximately three times the length of the second portion.

The length of the second portion 13, preferably made of steel, is susceptible to varying during the operation of the furnace, decreasing proportionally to the wear thereof. The first portion 12, having high thermal and electric conductivity, preferably made of copper, remains of constant length during the operation of the furnace.

The two portions 12, 13 of the metal bars 5 are preferably joined by means of welding or brazing 16 so as to ensure an adequate heat and electrical conduction and an adequate mechanical resistance. However, it is possible to also provide other types of couplings, for example by means of threaded coupling. In any case, there is a need for the type of connection made to ensure the passage of current and heat continuity. Advantageously, the zone of extension of the plurality of metal bars 5 on the lower electrode 3 and the fact that each of them is formed by two distinct and adjacent parts made of different materials, allow significantly improved cooling of the refractory layer of which the base sole 10 formed.

With reference to Figures 4b and 4c, according to a variant, the first portion 12' comprising the first axial end 6 and the second portion 13' comprising the second axial end 7 have different diameters, and the ratio between the diameter of the first portion 12' and the diameter of the second portion 13' is greater than one. The diameter of the first portion 12' is advantageously greater than the diameter of the second portion 13' so as to reduce the specific thermal flow at the first portion 12' and at the same time reduce the power generated due to the Joule effect from the passage of current, and therefore increase the overall cooling efficiency of the system.

Preferably, the passage between the diameter of portion 12' and the diameter of portion 13' is gradual, there being a tapered transition portion 18 (Fig. 4b), being part of, for example, portion 12', so as to avoid sudden variations which may cause localized wear of the bars. Preferably, according to this variant, at a zone 19 of the copper first portion 12' of each bar corresponding to the stretch of the first portion 12' inside gap 15, annular grooves are formed by means of removal of material, which are coaxial to the longitudinal axis of the bars and define corresponding annular tabs 14, for the purpose of increasing the heat exchange between the side surface of each first portion 12' and the cooling fluid which flows through gap 15. In this case, the end 6 has a diameter substantially equal to the diameter of the bottom surface of the annular grooves formed by removal of material.

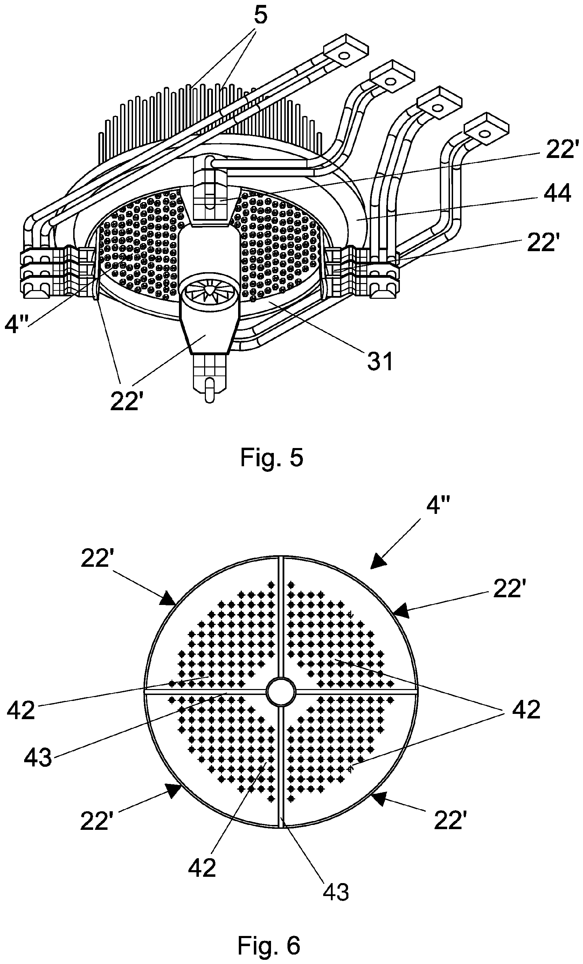

Figure 5 shows a variant wherein, instead of the power supply by means of the tubular casing 23, flange 40 is supplied electrically along the periphery thereof in order to obtain improved distribution of electric current through the metal bars 5, 5' of the lower electrode 3. In particular, the power supply occurs by means of electrical contacts 22' fixed to the skirt 31 of flange 40.

Indeed, skirt 31 is fixed by means of welding or brazing to the lower plate 4", to which the metal bars are fixed. Furthermore, there is a ring 44 of insulating material around skirt 31 and the upper plate 4' (not shown in Figure 5) to insulate the bottom electrode from the framework of the furnace. It is worth noting that the distribution of the electric current is of peripheral-radial type. This solution allows a more uniform passage of current and an improved thermal behavior of the bottom electrode described above, which is supplied with casing 23. A single, substantially central supply indeed involves increased wear of the metal bars close to such a supply due to the greater concentration of current with respect to the perimeter bars.

With reference to Figure 6, there is shown a variant of part of the bottom electrode. According to this variant, to further improve the uniformity of the electrical distribution to the metal bars 5, in addition to the lateral supply of the bottom electrode 3, the lower plate 4" is made of bimetallic sheet, for example in two parts, made of copper and steel, respectively, welded to each other. In particular, the lower plate 4" is formed by two layers: a first layer or upper layer, made of steel, and a second layer or lower layer, made of copper. The lower plate 4" has diameter slightly smaller than the diameter of skirt 31, it being contained in the area defined by the skirt, and the upper plate 4' has diameter greater than skirt 31, so as to protrude radially with respect thereto. Furthermore, four radial channels 43 are obtained along two orthogonal diameters in the copper lower layer of the lower plate 4", so as to form four sectors 42, or segments, separate from each other, each in contact with the steel upper layer. The radial channels 43 indeed leave uncovered the surface of the steel upper layer of the lower plate 4". Each sector 42 is supplied by a respective electrical contact 22'. An electrical discontinuity in the copper layer forming such sectors is ensured due to the separation into sectors 42. The use of the steel upper layer ensures the equipotentiality of the system and performs a structural function. The copper lower layer, divided into sectors 42, allows an improved control of the power supply of the metal bars fixed to each sector 42. The peripheral-radial type distribution of the current and the use of a lower plate 4"made of bimetallic sheet, of which the lower layer is made of greater electrical conductivity with respect to the upper layer, and in which the lower layer is divided into sectors, allows avoiding overload, checking the current supplied in each sector 42, standardizing and better managing the heat load and the distribution of the current on the single metal bars 5 forming the bottom electrode 3, in an optimal manner. Indeed, the current supplying each sector 42 of the lower layer tends to remain confined in such sectors, because they are made of material having a higher electrical conductivity, thus flowing through the bars 5 instead of being dispersed into the upper layer, which has lower electrical conductivity.

However, advantages of the same type are also obtained by using only some of such constructive features or other combinations thereof. For example, it is possible to use a lower plate, or in any case a support flange, which is made of bimetallic sheet that is not divided into sectors.

The temperatures reached in the safety and working layers of the furnace bottom according to the present invention are significantly lower with respect to the ones obtained in the bottom of a furnace of the state of the art. Indeed, experimental tests have shown that the temperature distribution of a furnace according to the state of the art determines higher values in the base sole with respect to the temperature field generated in a furnace according to the present invention. Less heating of the lower part of the furnace, and in particular of the base sole 10, subsequently has a smaller thermodynamic stress thereof. Furthermore, the temperatures at the insulating parts are also lower, thus ensuring less wear and therefore greater duration.

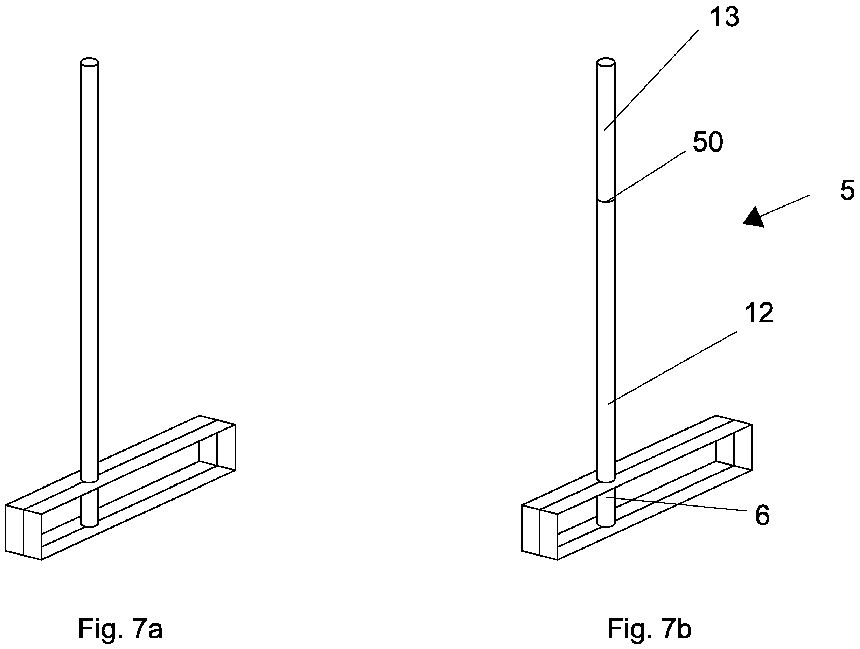

With reference to Figures 7a and 7b, an experimental test was performed for comparative reasons to determine the temperature profile of the bars during the operation of the furnace. Figure 7a shows a single bar of a plurality of bars, which are made only of steel. Figure 7b shows a single bar 5 of a plurality of bars according to the invention. Constructive and operating conditions being the same, except for the realization in a single material and in different materials of the bars, it has been advantageously discovered that the temperature close to the joining zone 50 between the first portion 12 and the second portion 13 is equal to approximately 450 °C and that the temperature close to the first end 6 is equal to approximately 250 °C. Instead, considering a zone of the bar in Fig. 7a, corresponding to the joining zone 50, and a zone of the bar in Fig. 7a, corresponding to the zone close to the first end 6, the temperatures detected are approximately 1600 °C and 800 °C, respectively. It is worth noting that a combination of the variants described does not depart from the scope of the present invention.

## Claims

1. A direct current electric arc furnace (1) for metallurgical plant comprising at least one bottom electrode (3) having a plurality of metal bars (5) parallel to one another and defining respective longitudinal axes, and a support flange (4) adapted to support and electrically supply said metal bars,
**characterized in that** each metal bar (5) comprises at least a first portion (12, 12') which includes a first end (6) of the bar (5), and at least a second portion (13, 13') which is axially adjacent to said first portion (12, 12') and which includes a second end (7) of the bar (5), said first portion (12, 12') being restrained to said support flange (4) at the first end (6), and having greater thermal conductivity with respect to said second portion (13, 13').

2. A furnace according to claim 1, wherein said support flange (4) comprises at least a first plate (4'), crossed by the metal bars (5) and distal from the first ends (6) of the bars, and at least a second plate (4") proximal to the first ends (6), the first plate (4') and the second plate (4") being substantially flat and parallel, and arranged so as to form a gap (15) between one another, and wherein each first end (6) is fixed to the second plate (4").

3. A furnace according to claim 2, wherein said second plate (4") is made of bimetallic sheet formed by a first layer, made of a first metal material, and of a second layer, adjacent to the first layer and made of a second metal material, and wherein said second metal material has greater electrical conductivity than the first metal material.

4. A furnace according to any one of the preceding claims, wherein said support flange (4) is provided with a metal conduit (23), which is fixed below the second plate (4") and communicating with said gap (15) for the passage of a cooling fluid.

5. A furnace according to any one of the claims from 2 to 4, wherein said support flange (4) is provided with a plurality of electrical contacts (22') arranged at respective peripheral positions of the second plate (4") and adapted to be connected to a power supply source.

6. A furnace according to claim 4, wherein said metal conduit (23) is adapted to be connected to a power supply source for distributing electric current to the second plate (4").

7. A furnace according to claim 5 or 6, wherein the second layer is divided into a plurality of sectors (42), preferably by means of a plurality of radial channels (43), so that each sector (42) is electrically supplied by said metal conduit (23) or by a respective electrical contact (22').

8. A furnace according to any one of the preceding claims, wherein the first portion (12, 12') and the second portion (13, 13') have circular section, and the diameter of the first portion (12, 12') is greater than or equal to the diameter of the second portion (13, 13').

9. A furnace according to claim 8, wherein, in the case of the first portion (12') having diameter greater than the second portion (13'), there are provided annular grooves on a stretch of the first portion (12') arranged inside the gap (15).

10. A furnace according to any one of the preceding claims, wherein the length of the first portion (12, 12') is greater than or equal to the length of the second portion (13, 13').

11. A furnace according to any one of the preceding claims, wherein there are provided at least one hundred metal bars (5) in said at least one bottom electrode (3).

12. A furnace according to any one of the preceding claims, wherein the first portion (12, 12') is made of copper or copper alloy and the second portion (13, 13') is made of steel.

13. A furnace according to claim 3, wherein the first metal material is steel and the second metal material is copper or copper alloy.

14. A furnace according to any one of the preceding claims, wherein the metal bars (5) are incorporated in a base sole (10) of the furnace, made of refractory material and arranged above said support flange (4).

## Patentansprüche

1. Gleichstromelektrolichtbogenofen (1) für ein metallerzeugendes Werk, der mindestens eine Bodenelektrode (3) umfasst, die mehrere Metallstangen (5), die parallel zueinander sind und entsprechende Längsachsen definieren, und einen Stützflansch (4) aufweist, der angepasst ist, um die Metallstangen zu stützen und elektrisch zu versorgen,
**dadurch gekennzeichnet, dass** jede Metallstange (5) mindestens einen ersten Abschnitt (12, 12'), der ein erstes Ende (6) der Stange (5) umfasst, und mindestens einen zweiten Abschnitt (13, 13') umfasst, der dem ersten Abschnitt (12, 12') axial benachbart ist und der ein zweites Ende (7) der Stange (5) umfasst, wobei der erste Abschnitt (12, 12') an dem Stützflansch (4) an dem ersten Ende (6) eingespannt ist und gegenüber dem zweiten Abschnitt (13, 13') eine höhere Wärmeleitfähigkeit aufweist.

2. Ofen nach Anspruch 1, wobei der Stützflansch (4) mindestens eine erste Platte (4'), die durch die Metallstangen (5) durchquert und distal von den ersten Enden (6) der Stangen ist, und mindestens eine zweite Platte (4") proximal zu den ersten Enden (6) umfasst, wobei die erste Platte (4') und die zweite Platte (4") im Wesentlichen flach und parallel sind und derart angeordnet sind, dass sie einen Zwischenraum (15) zwischen einander bilden, und wobei jedes erste Ende (6) an der zweiten Platte (4") befestigt ist.

3. Ofen nach Anspruch 2, wobei die zweite Platte (4") aus Bimetallblech hergestellt ist, das durch eine erste Schicht, die aus einem ersten Metallmaterial hergestellt ist, und einer zweiten Schicht gebildet ist, die der ersten Schicht benachbart ist und aus einem zweiten Metallmaterial hergestellt ist, und wobei das zweite Metallmaterial eine höhere elektrische Leitfähigkeit aufweist als das erste Metallmaterial.

4. Ofen nach einem der vorhergehenden Ansprüche, wobei der Stützflansch (4) mit einer Metallleitung (23) versehen ist, die unter der zweiten Platte (4") befestigt ist und mit dem Zwischenraum (15) für den Durchfluss eines Kühlmittels verbunden ist.

5. Ofen nach einem der Ansprüche 2 bis 4, wobei der Stützflansch (4) mit mehreren elektrischen Kontakten (22') versehen ist, die an entsprechenden Umfangspositionen der zweiten Platte (4") angeordnet sind und angepasst sind, um mit einer Stromversorgungsquelle verbunden zu sein.

6. Ofen nach Anspruch 4, wobei die Metallleitung (23) angepasst ist, um mit einer Stromversorgungsquelle zum Verteilen von elektrischem Strom an die zweite Platte (4") verbunden zu sein.

7. Ofen nach Anspruch 5 oder 6, wobei die zweite Schicht, vorzugsweise mittels mehrerer radialer Kanäle (43), in mehrere Sektoren (42) unterteilt ist, derart dass jeder Sektor (42) elektrisch durch die Metallleitung (23) oder durch einen entsprechenden elektrischen Kontakt (22') elektrisch versorgt wird.

8. Ofen nach einem der vorhergehenden Ansprüche, wobei der erste Abschnitt (12, 12') und der zweite Abschnitt (13, 13') einen kreisförmigen Querschnitt aufweisen und der Durchmesser des ersten Abschnitts (12, 12') größer als oder gleich dem Durchmesser des zweiten Abschnitts (13, 13') ist.

9. Ofen nach Anspruch 8, wobei in dem Fall, in dem der erste Abschnitt (12') einen Durchmesser aufweist, der größer als derjenige des zweiten Abschnitts (13') ist, ringförmige Rillen auf einer Strecke des ersten Abschnitts (12') bereitgestellt sind, die innerhalb des Zwischenraums (15) angeordnet ist.

10. Ofen nach einem der vorhergehenden Ansprüche, wobei die Länge des ersten Abschnitts (12, 12') größer als oder gleich der Länge des zweiten Abschnitts (13, 13') ist.

11. Ofen nach einem der vorhergehenden Ansprüche, wobei mindestens einhundert Metallstangen (5) in der mindestens einen Bodenelektrode (3) bereitgestellt sind.

12. Ofen nach einem der vorhergehenden Ansprüche, wobei der erste Abschnitt (12, 12') aus Kupfer oder Kupferlegierung hergestellt ist und der zweite Abschnitt (13, 13') aus Stahl hergestellt ist.

13. Ofen nach Anspruch 3, wobei das erste Metallmaterial Stahl ist und das zweite Metallmaterial Kupfer oder Kupferlegierung ist.

14. Ofen nach einem der vorhergehenden Ansprüche, wobei die Metallstangen (5) in einer Basissohle (10) des Ofens aufgenommen sind, die aus feuerfestem Material hergestellt ist und über dem Stützflansch (4) angeordnet ist.

## Revendications

1. Four à arc électrique à courant continu (1) pour usine métallurgique comprenant au moins une électrode inférieure (3) présentant une pluralité de barres métalliques (5) parallèles entre elles et définissant des axes longitudinaux respectifs, et une bride de support (4) adaptée pour supporter et alimenter électriquement lesdites barres métalliques,
**caractérisé en ce que** chaque barre métallique (5) comprend au moins une première partie (12, 12') qui comprend une première extrémité (6) de la barre (5) et au moins une seconde partie (13, 13') qui est axialement adjacente à ladite première partie (12, 12') et qui comprend une seconde extrémité (7) de la barre (5), ladite première partie (12, 12') étant retenue à ladite bride de support (4) à la première extrémité (6) et présentant une conductivité thermique supérieure à celle de ladite seconde partie (13, 13').

2. Four selon la revendication 1, dans lequel ladite bride de support (4) comprend au moins une première plaque (4'), traversée par les barres métalliques (5) et distale des premières extrémités (6) des barres, et au moins une seconde plaque (4") proximale des premières extrémités (6), la première plaque (4') et la seconde plaque (4") étant sensiblement plates et parallèles, et disposées de manière à former un espace (15) entre elles et dans lequel chaque première extrémité (6) est fixée à la seconde plaque (4").

3. Four selon la revendication 2, dans lequel ladite seconde plaque (4") est constituée d'une feuille bimétallique formée par une première couche, constituée d'un premier matériau métallique, et d'une seconde couche, adjacente à la première couche et constituée d'un second matériau métallique, et dans lequel ledit second matériau métallique présente une conductivité électrique supérieure à celle du premier matériau métallique.

4. Four selon l'une quelconque des revendications précédentes, dans lequel ladite bride de support (4) est munie d'un conduit métallique (23) qui est fixé sous la seconde plaque (4") et communiquant avec ledit espace (15) pour le passage d'un fluide de refroidissement.

5. Four selon l'une quelconque des revendications 2 à 4, dans lequel ladite bride de support (4) est munie d'une pluralité de contacts électriques (22') disposés à des positions périphériques respectives de la deuxième plaque (4") et conçus pour être connectés à une source d'alimentation électrique.

6. Four selon la revendication 4, dans lequel ledit conduit métallique (23) est conçu pour être connecté à une source d'alimentation électrique pour distribuer le courant électrique à la seconde plaque (4").

7. Four selon la revendication 5 ou 6, dans lequel la seconde couche est divisée en une pluralité de secteurs (42), de préférence au moyen d'une pluralité de canaux radiaux (43), de sorte que chaque secteur (42) est alimenté électriquement par ledit conduit métallique (23) ou par un contact électrique respectif (22').

8. Four selon l'une quelconque des revendications précédentes, dans lequel la première partie (12, 12') et la seconde partie (13, 13') présentent une section circulaire, et le diamètre de la première partie (12, 12') est supérieur ou égal au diamètre de la seconde partie (13, 13').

9. Four selon la revendication 8, dans lequel, dans le cas où la première partie (12') présente un diamètre supérieur à celui de la seconde partie (13'), des rainures annulaires sont prévues sur une extension de la première partie (12') disposée à l'intérieur de l'espace (15).

10. Four selon l'une quelconque des revendications précédentes, dans lequel la longueur de la première partie (12, 12') est supérieure ou égale à la longueur de la seconde partie (13, 13').

11. Four selon l'une quelconque des revendications précédentes, dans lequel au moins une centaine de barres métalliques (5) sont prévues dans ladite au moins une électrode inférieure (3).

12. Four selon l'une quelconque des revendications précédentes, dans lequel la première partie (12, 12') est faite de cuivre ou d'alliage de cuivre et la seconde partie (13, 13') est faite d'acier.

13. Four selon la revendication 3, dans lequel le premier matériau métallique est de l'acier et le second matériau métallique est du cuivre ou un alliage de cuivre.

14. Four selon l'une quelconque des revendications précédentes, dans lequel les barres métalliques
(5) sont intégrées à une semelle de base (10) du four, réalisée en matériau réfractaire et disposée au-dessus de ladite bride de support (4).
